(19) Europäisches Patentamt / European Patent Office / Office européen des brevets

(11) **EP 3 405 796 B1**

(12) **FASCICULE DE BREVET EUROPEEN**

(45) Date de publication et mention de la délivrance du brevet:
**18.05.2022 Bulletin 2022/20**

(21) Numéro de dépôt: **17712184.5**

(22) Date de dépôt: **09.01.2017**

(51) Classification Internationale des Brevets (IPC):
*G01R 15/18* (2006.01)    *H02H 7/04* (2006.01)
*H01F 38/32* (2006.01)    *G01R 1/36* (2006.01)
*H01F 38/28* (2006.01)    *H01F 38/30* (2006.01)
*G01R 31/00* (2006.01)

(52) Classification Coopérative des Brevets (CPC):
**G01R 15/183; G01R 1/36; H01F 38/28;**
G01R 31/008; H01F 2038/305

(86) Numéro de dépôt international:
**PCT/FR2017/050046**

(87) Numéro de publication internationale:
**WO 2017/125661 (27.07.2017 Gazette 2017/30)**

(54) **DISPOSITIF DE MESURE DE COURANT PROTEGE CONTRE LES SURTENSIONS EN CAS D'OUVERTURE DU CIRCUIT**

STROMMESSUNGSVORRICHTUNG MIT ÜBERSPANNUNGSSCHUTZ BEI OFFENEM SCHALTKREIS

CURRENT MEASURING DEVICE PROTECTED AGAINST SURGE VOLTAGES IF THE CIRCUIT IS OPENED

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.01.2016 FR 1650526**

(43) Date de publication de la demande:
**28.11.2018 Bulletin 2018/48**

(73) Titulaire: **Safran Electrical & Power**
**31702 Blagnac Cedex (FR)**

(72) Inventeur: **HENRARD, Pierre, Henri**
**31702 BLAGNAC CEDEX (FR)**

(74) Mandataire: **Cabinet Beau de Loménie**
**158, rue de l'Université**
**75340 Paris Cedex 07 (FR)**

(56) Documents cités:
**WO-A2-2009/047748    CN-A- 103 762 557**
**US-A1- 2012 050 923    US-A1- 2015 333 509**

**Description**

Arrière-plan de l'invention

L'invention se rapporte au domaine général instruments de mesure de courant et plus particulièrement aux transformateurs d'intensités destinés à être embarqués à bord d'un aéronef.

L'utilisation de transformateurs d'intensité, notés TI en français ou CT en anglais pour « Current Transformer », est courante en aéronautique sur les réseaux alternatifs (AC) de 115 VAC ou 230 VAC. Les TI servent à mesurer les courants de ligne alternatifs des réseaux avion qui sont en général des courants AC triphasés.

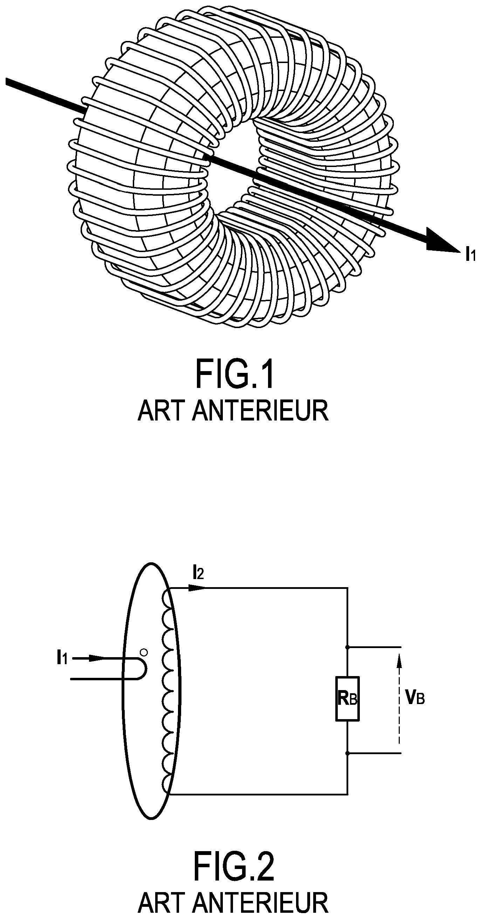

Comme cela est illustré sur la figure 1, un TI est constitué d'un circuit magnétique qui est en général de forme torique de manière à minimiser les fuites magnétiques et sur lequel on a bobiné un nombre n de spires secondaires fermées sur une résistance de charge. Sur ces spires circule un courant noté $I_2$. Le courant, noté $I_1$, dans la barre à mesurer traverse au minimum une fois le tore ainsi constitué. Dans l'exemple présenté ici et illustré notamment sur la figure 2 qui présente un schéma électrique simplifié d'un TI, on considérera que le nombre de tours primaires est égal à un (cas habituel en aéronautique).

Un TI répond au théorème d'Ampère représenté mathématiquement par l'équation suivante :

$$\oint \vec{H}\overrightarrow{dl} = -I_1 + nI_2$$

où $I_1$ est le courant à mesurer qui traverse le tore, $I_2$ correspond au courant de mesure obtenu en enroulant n spires autour du noyau magnétique, et H est le champ magnétique qui sert à magnétiser le tore.

Si on néglige la circulation du champ magnétique dans le noyau, c'est-à-dire si on considère $\oint \vec{H}\overrightarrow{dl} = 0$, on obtient alors la relation $I_1 = nI_2$.

Le circuit secondaire est chargé par une résistance de charge, notée $R_B$ sur la figure 2, qui permet, par mesure de la tension aux bornes de cette résistance de charge, de déduire la tension $V_B$ au secondaire du tore, qui vaut

$$V_B = R_B I_2 = R_B \frac{I_1}{n}$$

, au courant magnétisant près, et ainsi de déterminer le courant $I_1$ circulant dans la barre traversant le tore.

Les TI présentent ainsi l'intérêt d'être capables de transmettre aux organes de contrôle et de protection, notés respectivement GCU pour « General Control Unit » en anglais et BPCU pour « Bus Power Control Unit » en anglais, une mesure assez peu sensible à l'environnement électromagnétique dans l'avion. Ainsi, ils peuvent être aisément déportés des organes de décision, de quelques décimètres à plusieurs dizaines de mètres à bord d'un avion.

Cependant, leur utilisation pose un problème. Lorsqu'un TI est ouvert (absence de résistance de charge), c'est-à-dire lorsque la liaison entre le TI et son récepteur, un GCU ou un BPCU ou même un autre organe, est coupée, une haute tension est générée en sortie des enroulements secondaires du TI. L'absence de circulation de courant au secondaire entraine en effet une égalité entre la circulation du champ magnétisant qui sert à magnétiser le tore et le courant primaire. On a ainsi $\oint \vec{H}\overrightarrow{dl} = -I_1$.

L'amplitude du courant primaire à mesurer étant généralement assez élevée, l'induction B dans le circuit magnétique passe à saturation de manière très rapide à chaque inversion du passage du courant primaire. En appliquant la loi de Lenz au secondaire du TI, $V = n\,d\varphi/dt$, avec $\varphi$ le flux électromagnétique échangé entre le primaire et le secondaire, on constate que la tension va prendre des valeurs très importantes à chaque variation brutale du courant magnétisant. Cette tension dépend du nombre de spires secondaires, du type de noyau magnétique, ainsi que de la valeur du courant primaire à mesurer.

Cette haute tension qui dépend de la valeur du courant mesuré peut aisément dépasser quelques kilovolts. Elle peut mener au développement d'arcs électriques en sortie du TI ou au sein même de ses enroulements. Le déclenchement de ces phénomènes dépend donc du niveau de courant circulant dans les lignes que l'on souhaite mesurer mais aussi du matériau magnétique utilisé pour le TI ainsi que de son nombre de spires secondaires.

Cela peut présenter un risque non négligeable au niveau d'un avion car ces phénomènes restent entretenus lorsqu'ils ne sont pas détectés et peuvent entrainer un départ de feu.

Il existe trois principaux types de familles de protection pour les TI : les protections par adjonction d'un écrêteur bidirectionnel, les protections par adjonction d'une résistance en parallèle sur la sortie du TI, et les protections par adjonction d'un condensateur.

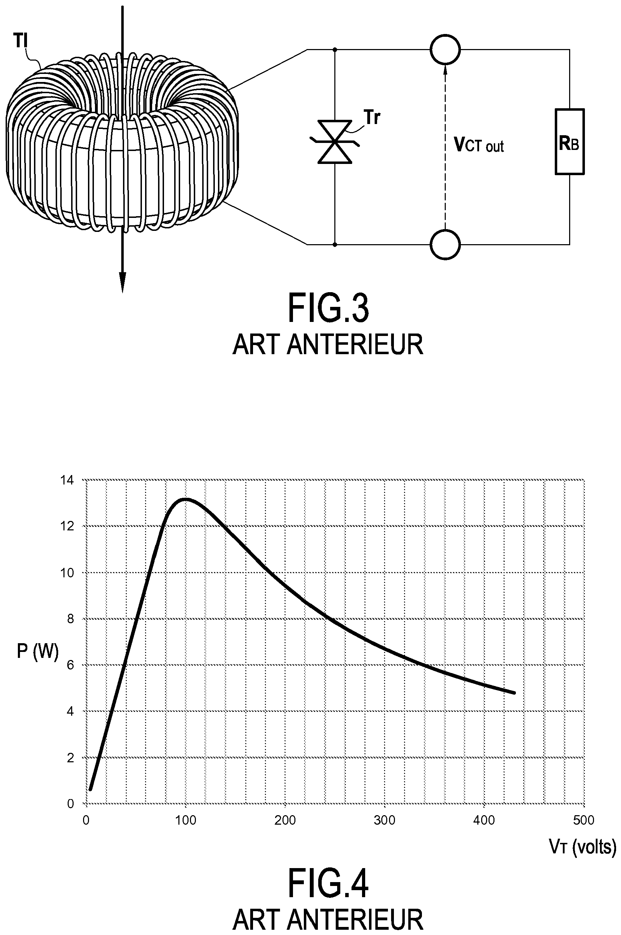

Comme cela est illustrée sur la figure 3, une protection par écrêteur est réalisée en montant un écrêteur Tr, tel qu'un tranzorb par exemple, entre les deux sorties du TI. L'écrêteur est réglé à une tension supérieure à la tension maximale $V_{CT\_out}$ à mesurer aux bornes de la résistance de charge $R_B$. La puissance dissipée par l'écrêteur lorsque le TI est ouvert peut s'exprimer ainsi :

$$< P >= \frac{V_T}{n\pi} I_{primaire\_eff} \sqrt{2} (1 - \cos(\omega \Delta t))$$

Avec $\Delta t = nS \frac{\Delta B_{cc}}{V_T} = f(V_T)$ , et où $V_T$ représente la tension d'écrêtage, $\Delta t$ la durée de l'écrêtage, $\omega$ la pulsation du réseau électrique de puissance, S la surface utile du matériau magnétique, $\Delta B_{cc}$ l'induction crête à crête maximale du matériau magnétique, n le nombre de tours secondaires, et $I_{primaire\_eff}$ le courant efficace primaire pour lequel on souhaite protéger le TI.

Les pertes vont dépendre de la tension d'écrêtage comme cela est illustré sur la figure 4, mais aussi du courant primaire, du nombre de spires, de la section du noyau et du niveau de saturation du matériau magnétique.

Pour une application sur un réseau triphasé 90 kVA/400Hz, la tension d'écrêtage devra être choisie en général supérieure à 40 volts. Ainsi, si on estime les pertes du TI (hors pertes fer du noyau), on trouve la répartition suivante : 0,36W pour les pertes cuivre dans le secondaire, et 6,25W pour la protection de type écrêteur. Etant donné les pertes très importantes pour la protection de type écrêteur, il faut prévoir un dissipateur pour évacuer la puissance dissipée par cette protection car l'écrêteur risque de ne pas tenir thermiquement.

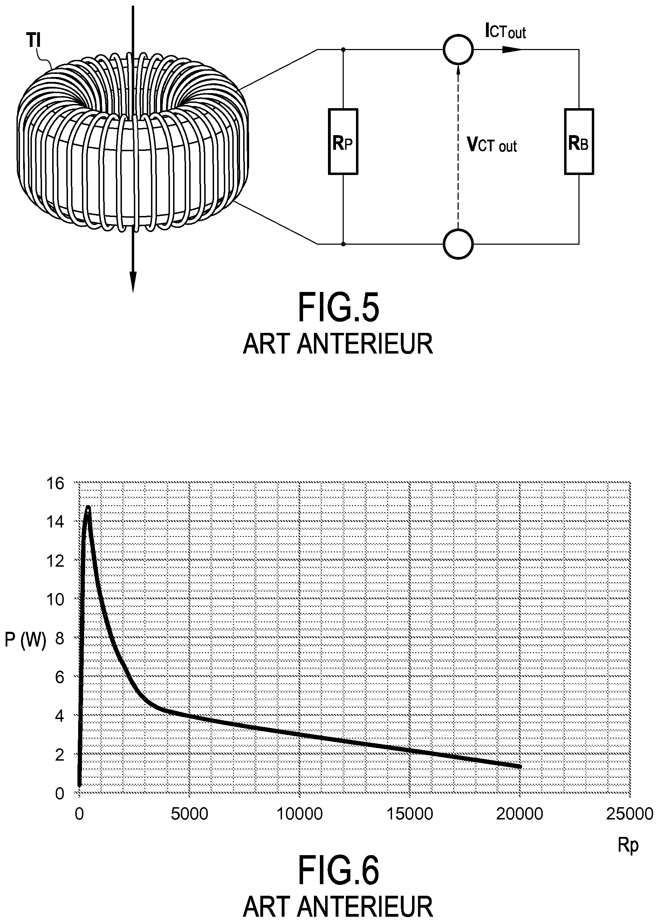

Comme cela est illustré sur la figure 5, le montage classiquement utilisé pour une protection par adjonction d'une résistance en parallèle de la sortie du TI se compose du TI, d'une résistance de charge $R_B$ pour la mesure et d'une résistance $R_p$ montée en parallèle de la résistance de charge $R_B$ en sortie du TI.

Les pertes dans la résistance parallèle $R_p$ en fonction de sa valeur sont représentées par la courbe de la figure 6. Cette courbe a été obtenue à partir d'un modèle de simulation numérique.

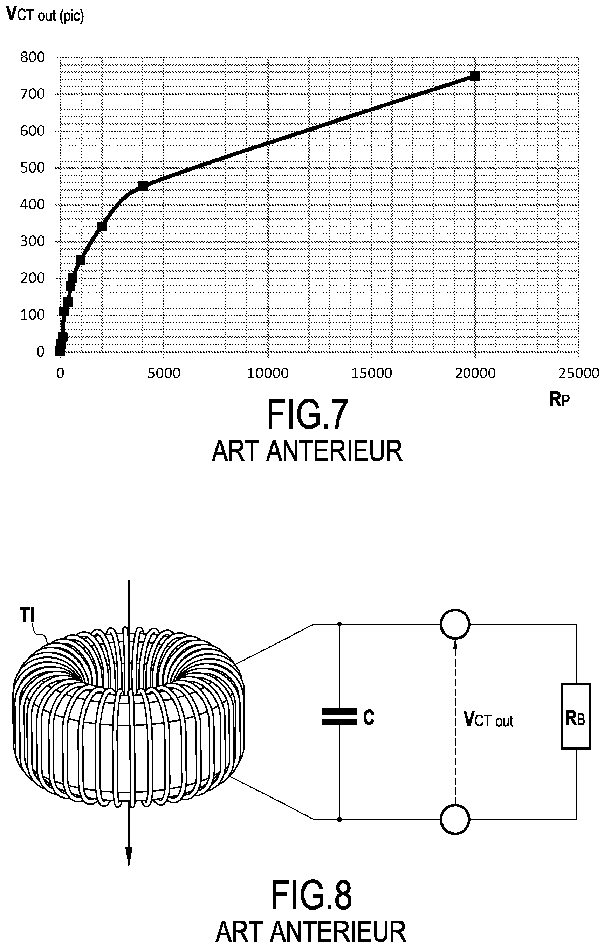

Comme cela est illustrée sur la courbe de la figure 7, lorsque la résistance parallèle Rp est très élevée, les pertes sont réduites mais la surtension est très peu atténuée. En revanche, lorsque la résistance est très faible, c'est-à-dire de l'ordre de la centaine d'ohms maximum, les pertes sont faibles et la tension de sortie limitée, mais dans ce cas la précision n'est pas très élevée. En effet, le courant mesuré dépend alors de l'impédance de ligne dont la valeur ne peut être connue avec une grande précision.

Le courant $I_{CTout}$ circulant dans la résistance de mesure peut s'exprimer en fonction du courant primaire d'entrée :

$$I_{CTout} = \frac{i_1}{n} \frac{R_p}{(R_p + R_B + R_l)}$$

On remarque que l'erreur faite sur le courant mesuré sera de l'ordre de grandeur de la somme des précisions relatives des résistances $R_p$, $R_l$ et $R_B$. Autant $R_B$ et $R_p$ peuvent être précises, autant $R_l$ est soumise à l'imprécision sur la connaissance de la longueur de la ligne.

Comme cela est illustré sur la figure 8, le montage classiquement utilisé pour une protection par adjonction d'un condensateur se compose du TI, d'une résistance de charge $R_B$ et d'un condensateur C monté en parallèle en sortie du TI.

Pour ce type de protection, il est nécessaire de bien dimensionner la valeur de capacité du condensateur. Pour dimensionner la valeur de la capacité optimale, on considère que lorsque la résistance de charge $R_B$ est déconnectée, la tension de sortie doit être inférieure à la tension de saturation pour une valeur du courant efficace $I_{1eff}$ circulant dans la spire primaire donnée (en général le courant nominal primaire).

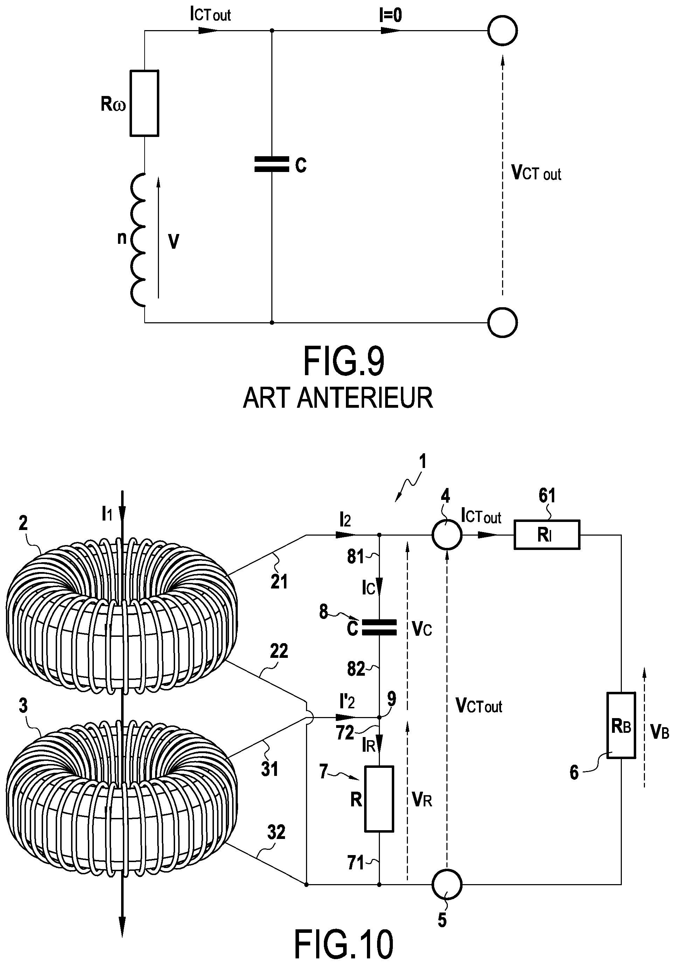

On établit un modèle équivalent représenté sur la figure 9 dans lequel le courant $I_C$ circulant dans le condensateur vaut $I_1(t)/n$, avec n le nombre d'enroulements secondaires du TI, et comprenant une résistance $R_\omega$ correspondant à la résistance de l'enroulement secondaire.

On écrit que le courant $I_C$ dans la capacité vaut aussi :

$$I_C = C \frac{dV_{CTout}}{dt}$$

Avec C la valeur de la capacité du condensateur et $V_{CTout}$ la tension aux bornes du TI et donc aux bornes du condensateur.

La tension de aux bornes des enroulements vaut :

$$V = V_{CTout} + R_\omega I_{CTout} = \frac{1}{C} \int I_{CTout}\, dt + R_\omega I_{CTout}$$

Avec $I_{CTout}$ le courant délivré par le TI, c'est-à-dire au niveau du modèle équivalent, le courant circulant dans l'enroulement et la résistance de l'enroulement secondaire $R_\omega$.

Le courant circulant dans la capacité peut aussi être exprimé en fonction du courant primaire $I_{1eff}$.

$$I_{CTout} = \frac{I_{1eff}}{n} \sqrt{2}\, \sin(\omega t)$$

Ainsi en régime sinusoïdal, on a :

$$V = \left(-j\frac{1}{C\omega} + R_\omega\right) I_{CTout}$$

On en déduit :

$$\|V\| = \sqrt{\left(\frac{1}{(C\omega)^2} + R_\omega^2\right)}\, \|I_{CTout}\| = \sqrt{\left(\frac{1}{(C\omega)^2} + R_\omega^2\right)}\, \frac{I_{1eff}}{n} \sqrt{2}$$

En écrivant la loi de Lentz :

$$V = n\frac{d\varphi}{dt} = nS\frac{dB}{dt}$$

elle aussi en régime sinusoïdal :

$$\|V\| = nS\omega\|B\|$$

On en déduit que :

$$nS\omega\|B\| = \sqrt{\left(\frac{1}{(C\omega)^2} + R_\omega^2\right)}\, \frac{I_{1eff}}{n} \sqrt{2}$$

En développant :

$$\frac{n^2 S\omega\|B\|}{I_{1eff}\sqrt{2}} = \sqrt{\left(\frac{1}{(C\omega)^2} + R_\omega^2\right)}$$

$$\left(\frac{n^2 S\omega\|B\|}{I_{1eff}\sqrt{2}}\right)^2 = \left(\frac{1}{(C\omega)^2} + R_\omega^2\right)$$

$$\frac{1}{(C\omega)^2} = \left(\frac{n^2 S\omega \|B\|}{I_{1eff}\sqrt{2}}\right)^2 - R_\omega^2$$

Finalement on trouve :

$$C = \frac{1}{\omega}\sqrt{\frac{1}{\left(\dfrac{n^2 S\omega \|B\|}{I_{1eff}\sqrt{2}}\right)^2 - R_\omega^2}}$$

On choisira la valeur de capacité supérieure à la valeur précédemment déterminée afin d'assurer la non saturation du noyau magnétique.

$$C > \frac{1}{\omega}\sqrt{\frac{1}{\left(\dfrac{n^2 S\omega\, B_{max}}{I_{1eff}\sqrt{2}}\right)^2 - R_\omega^2}}$$

L'inconvénient majeur de cette solution est qu'elle peut difficilement être utilisée pour réaliser des protections différentielles. En effet lors d'un court-circuit, le courant capacitif peut être identifié par la protection différentielle comme un courant de défaut différentiel.

Il existe d'autres protections faisant généralement appel à une électronique active qui réduit la fiabilité de l'ensemble du dispositif de mesure du courant comportant le TI. C'est pour cette raison que ce type de protection n'est pas retenu.

L'adjonction de protections, tels que des résistances entre autre, sur le TI entraine généralement une perte de précision sur la mesure de sortie finale. Cette perte de précision génère alors un besoin de remonter les seuils de détection des défauts, notamment pour les défauts différentiels.

De plus, ces protections ne peuvent généralement pas supporter un défaut permanent. Elles peuvent donc elles aussi entraîner une surchauffe et un départ de feu.

Des exemples de circuits de protection de transformateurs de courant sont divulgués dans les documents US 2012/050923 A1, US 2015/333509 A1 et WO 2009/047748 A2.

Objet et résumé de l'invention

L'invention vise à fournir une protection efficace pour protéger à la fois un dispositif de mesure de courant comportant un transformateur d'intensité, et les opérateurs tout en conservant une précision suffisante pour répondre aux demandes avionneurs.

Il est proposé pour cela, selon un objet de l'invention, un dispositif de mesure d'un courant protégé contre les surtensions en cas d'ouverture du circuit dudit dispositif, le dispositif comprenant les caractéristiques de la revendication indépendante 1.

L'objet selon la présente invention permet de se prémunir de la perte de précision due à l'adjonction d'une protection contre les surtensions de type résistive ou capacitive tout en supprimant, en cas d'ouverture du TI, tout risque de génération d'une haute tension dangereuse. En effet, la tension générée est une tension non destructive pour le TI et suffisamment basse pour ne pas électriser un opérateur (V<40V).

Le dispositif de mesure selon l'invention peut être implémenté sur tout équipement dont l'accès n'est pas aisé sur un avion, comme par exemple des générateurs montés en nacelle, et évite ainsi la dépose et la réparation en usine suite à un défaut d'ouverture du secondaire du TI.

La précision obtenue par la présente invention offre une compatibilité du dispositif aux besoins d'un avion pour lequel les niveaux de détection de défauts différentiels doivent être très faibles, c'est-à-dire de l'ordre de la dizaine d'ampères, comme par exemple pour l'avion « Carbone ».

L'objet selon l'invention présente en outre de moindres pertes comparé à une solution connue utilisant un simple écrêteur en parallèle lorsque le circuit est ouvert. L'invention permet aussi de tenir des surcharges en courant plus importantes en cas de défaut.

La résistance de charge, ou résistance de mesure, peut correspondre à la résistance interne d'un moyen de mesure couplé entre les première et seconde bornes de connexion dudit dispositif de mesure de courant.

Selon un premier aspect du dispositif de mesure de courant protégé contre les surtensions en cas d'ouverture de circuit, la résistance de protection peut posséder une valeur ohmique correspondant, à 20% près et plus particulièrement à 10% près, à la somme de la valeur ohmique de la résistance de charge avec la valeur ohmique de l'impédance de ligne correspondant à la résistance de la ligne électrique couplant la résistance de charge aux première et seconde bornes de connexion.

Dans cette configuration, le potentiel sur la première borne de connexion est identique, ou presque, au potentiel sur la seconde borne de la résistance de protection à laquelle le condensateur et le second transformateur d'intensité sont raccordés. Les deux bornes du condensateur présentant ainsi un potentiel identique ou presque, aucun courant ou presque ne circule dans le moyen de dérivation en fonctionnement nominal, c'est-à-dire tant que le TI n'est pas ouvert. Par conséquent, tout le courant délivrer par le premier transformateur d'intensité est transmis à la résistance de charge améliorant ainsi la précision de la mesure de courant.

Selon un second aspect du dispositif de mesure de courant protégé contre les surtensions en cas d'ouverture de circuit, les transformateurs d'intensité sont de préférence des tores magnétiques identiques possédant notamment le même noyau magnétique et le même nombre de spires.

La forme de torique du transformateur d'intensité permet de minimiser les fuites magnétiques.

L'identité des deux transformateurs d'intensité permet d'avoir une identité des courants délivrés en sortie des deux tores magnétiques, ce qui permet de minimiser voire d'annuler le courant parasite traversant le moyen de dérivation du courant.

Selon un troisième aspect du dispositif de mesure de courant protégé contre les surtensions en cas d'ouverture de circuit, le moyen de dérivation du courant peut comprendre un condensateur.

En variante, le moyen de dérivation du courant peut comprendre un moyen d'écrêtage tel qu'un tranzorb.

Dans une autre variante, le moyen de dérivation du courant peut comprendre un montage en parallèle d'une première branche comportant un nombre k de diodes montées en série dans un premier sens passant avec une seconde branche comportant un même nombre k de diodes montées en série dans un second sens passant opposé au premier sens passant.

Dans une encore autre variante, le moyen de dérivation du courant peut comprendre un montage en série de deux diodes Zener tête bêches.

Selon un quatrième aspect du dispositif de mesure de courant protégé contre les surtensions en cas d'ouverture de circuit, le dispositif peut comprendre en outre un dispositif de détection de défaut des moyens de mesure du courant de la tension aux bornes de la résistance de charge.

Ainsi, pour les applications ne nécessitant pas de protections différentielles, comme par exemple les mesures des courants sur groupes de parc, le dispositif de mesure permet de se prémunir de tout problème lié à l'ouverture du circuit secondaire, tout en évitant une panne cachée sur la fonction « mesure du courant ». Le dispositif de détection de défaut peut être assez simple et être implémenté dans l'électronique de mesure. Le dispositif de détection de défaut peut par exemple comprendre une résistance de Pull-up sur la résistance de charge.

Dans un autre objet de l'invention, il est proposé un système de mesure triphasé des courants circulant dans les trois phases d'un circuit triphasé, le système comprenant trois dispositifs de mesure tels que définis ci-dessus, les secondes bornes de connexion des dispositifs étant couplées ensemble.

Dans encore un autre objet de l'invention, il est proposé un aéronef comprenant au moins un dispositif de mesure du courant tel que défini ci-dessus.

Brève description des dessins.

L'invention sera mieux comprise à la lecture faite ci-après, à titre indicatif mais non limitatif, en référence aux dessins annexés sur lesquels :

- la figure 1, déjà décrite, présente une vue simplifiée en perspective d'un transformateur d'intensité selon l'état de la technique ;
- la figure 2, déjà décrite, représente un schéma électrique d'un modèle simplifié d'un dispositif de mesure de courant doté d'un transformateur d'intensité connu selon l'état de la technique ;
- la figure 3, déjà décrite, représente schématiquement un dispositif de mesure de courant doté d'un transformateur d'intensité avec une protection par écrêteur selon l'état de la technique ;
- la figure 4, déjà décrite, est une représentation graphique de la puissance dissipée par la protection de type écrêteur de la figure 3 en fonction de la tension d'écrêtage avec un transformateur d'intensité présentant 1000 tours secondaires pour un courant nominal primaire défini;
- la figure 5, déjà décrite, présente schématiquement un dispositif de mesure de courant doté d'un transformateur d'intensité avec une protection par résistance de protection selon l'état de la technique ;

- la figure 6, déjà décrite, est une représentation graphique de la puissance dissipée par la protection par résistance de la figure 5 en fonction de la tension d'écrêtage avec un transformateur d'intensité présentant 1000 tours secondaires pour un courant nominal primaire défini ;
- la figure 7, déjà décrite, est une représentation graphique de la tension de sortie du transformateur d'intensité de la figure 5 à vide en fonction de la valeur de la résistance parallèle lorsque la résistance de charge est déconnectée ;
- la figure 8, déjà décrite, présente schématiquement un dispositif de mesure de courant doté d'un transformateur d'intensité avec une protection par condensateur de protection selon l'état de la technique ;
- la figure 9, déjà décrite, présente schéma électrique d'un modèle équivalent du transformateur d'intensité de la figure 8 ;
- la figure 10 présente schématiquement un dispositif de mesure de courant selon un premier mode de réalisation de l'invention ;
- la figure 11 est une représentation graphique de l'erreur x faite sur la mesure du courant primaire paramétré en fonction de la valeur de la résistance de protection du dispositif de mesure du courant de la figure 10 ;
- la figure 12 est une représentation graphique du déphasage entre le courant à mesurer et le courant mesuré paramétré en fonction de la valeur de la résistance de protection du dispositif de mesure du courant de la figure 10 ;
- la figure 13 présente schématiquement un dispositif de mesure de courant selon un second mode de réalisation de l'invention.

Description détaillée de modes de réalisation

Sur la figure 10 est représenté schématiquement un circuit électrique d'un dispositif de mesure de courant selon un premier mode de réalisation de l'invention.

Le dispositif de mesure de courant 1 comprend un premier transformateur d'intensité ayant la forme d'un tore magnétique 2 possédant un premier nombre $N_1$ de spires, c'est-à-dire de tours, et un second transformateur d'intensité ayant la forme d'un tore magnétique 3 possédant un second nombre $N_2$ de spires égale au premier nombre $N_1$ de spires. Les noyaux du premier tore magnétique 2 et du second tore électromagnétique 3 sont réalisés dans le même matériau et ont les mêmes dimensions. Ainsi, les premier et second tores magnétiques 2 et 3 sont identiques.

Le premier tore magnétique 2 présente une première borne de couplage 21 et une seconde borne de couplage 22. Le second tore magnétique 3 présente une première borne de couplage 31 et une seconde borne de couplage 32.

Le dispositif de mesure de courant 1 comprend en outre une première borne de connexion 4 et une seconde borne de connexion 5, ainsi qu'une résistance de charge 6 raccordée entre les première et seconde bornes de connexion 4 et 5. La résistance de charge 6 permet de réaliser une mesure de tension pour déterminer le courant circulant dans un circuit traversant le premier tore magnétiques 2.

La première borne de connexion 4 est raccordée en outre à la première borne de couplage 21 du premier tore magnétique 2 tandis que la seconde borne de connexion 5 est raccordée en outre à la seconde borne de couplage 32 du second tore magnétique 3 et à la seconde de couplage 22 du premier tore magnétique 2.

Le dispositif de mesure de courant 1 comprend en outre une résistance de protection 7 et un moyen de dérivation du courant formé dans le premier mode de réalisation illustré sur la figure 10 par un condensateur 8.

La résistance de protection 7 présente une première borne 71 raccordée à la seconde borne de connexion 5 et une seconde borne 72 raccordée à la première borne de couplage 31 du second tore magnétique 3.

Le condensateur 8 présente une première borne 81 raccordée à la première borne de connexion 4 et une seconde borne 82 raccordée à la première borne de couplage 31 du second tore magnétique 3 et donc à la seconde borne 72 de la résistance de protection 7.

Le noeud d'interconnexion formé par le raccordement de la première borne de couplage 31 du second tore magnétique 3 avec la seconde borne 72 de la résistance de protection 7 et la seconde borne 82 du condensateur 8 possède la référence numérique 9.

En fonctionnement nominal, le premier tore magnétique 2 génère un premier courant $I_2$, dit courant de mesure, et le second tore magnétique 3 génère un second courant $I_2'$. Le second courant $I_2'$ est essentiellement injecté dans la résistance de protection 7. Les premier et second tores magnétiques 2 et 3 étant identiques et traversés par le même circuit dont le courant $I_1$ est à mesurer, les premier et second courant $I_2$ et $I_2'$ sont identiques ou presque.

La résistance de protection 7 est choisie pour être égale ou avoir une valeur la plus proche possible à la somme de l'impédance de ligne, représentée sur le schéma électrique par la résistance 61, et de la résistance de charge 6.

L'égalité entre le premier courants $I_2$ et le second courant $I_2'$ et l'égalité entre la résistance de protection 7 et la somme de l'impédance de ligne 61 avec la résistance de charge permet ainsi d'avoir une tension $V_R$ aux bornes 71 et 72 de la résistance de protection 7 égale à la tension $V_{CTout}$ mesurée entre la première borne de connexion 4 et la seconde borne de connexion 5. Le potentiel au noeud d'interconnexion 9 étant égal, ou très proche, au potentiel de la première borne de connexion 4, la tension $V_C$ aux bornes 81 et 82 du condensateur 8 est nulle ou quasi nulle et donc le courant $I_C$ qui le traverse est également nul ou quasi nul.

Cela permet ainsi de minimiser voire d'annuler le courant capacitif parasite $I_C$ traversant le condensateur 8 pendant le fonctionnement nominal du dispositif de mesure de courant 1, le fonctionnement nominal correspondant au fonctionnement en circuit fermé permettant la mesure du courant $I_1$ du circuit traversant les premier et second tores magnétiques 2 et 3.

L'impédance de ligne 61 peut être assimilée à la résistance du fil entre la première borne de connexion 4 et la résistance de charge 6, d'une part, et entre la résistance de charge 6 et la seconde borne de connexion 5, d'autre part. En effet, l'impédance due à l'inductance du câblage est négligeable devant la valeur de résistance du fil.

En considérant que la résistance de ligne peut être connue avec une certaine tolérance de l'ordre de 10% à 20% et que la résistance de charge peut être connue avec une tolérance inférieure ou égale à 1%, on peut déterminer l'erreur de mesure maximale générée par le dispositif de mesure de courant 1.

En cas de déconnexion de la résistance de charge 6, le courant de mesure $I_2$ du dispositif de mesure de courant 1 passe intégralement dans le condensateur 8. Le courant $I_R$ circulant dans la résistance de protection est alors doublé.

On peut exprimer le courant de sortie $I_{CTout}$ délivrée en sortie de la première borne de connexion 4 à la résistance de charge 6 en fonction du courant primaire d'entrée $I_1$, c'est-à-dire en fonction du courant du circuit traversant les premier et second tores magnétiques, en négligeant le courant magnétisant.

La mise en équation est la suivante :

$$\begin{cases} i_2' = x\, i_2 & (1) \\ V_C + V_R = V_{CTout} & (2) \\ i_C = i_2 - i_{CTout} & (3) \\ i_R = i_2 + i_2' - i_{CTout} & (4) \\ i_C = jC\omega V_C & (5) \\ i_R = \dfrac{V_R}{R} & (6) \\ i_{CTout} = \dfrac{V_{CTout}}{(R_l + R_B)} & (7) \end{cases}$$

Avec R la valeur de la résistance de protection 7, $R_l$ la valeur de l'impédance de ligne 61, $R_B$ la valeur de la résistance de charge 6, C la valeur de la capacité du condensateur 8, et x correspondant au rapport des nombres de tours des deux tores (x=N1/N2) sachant qu'en théorie N1=N2.

A partir de ce système d'équation, on trouve alors la fonction de transfert suivante :

$$\frac{i_{CTout}}{i_2} = \frac{1 + jRC\omega\,(\,1 + x)}{(1 + j(R_l + R_B + R)C\omega)}$$

Le rapport des modules s'écrit:

$$\frac{\|i_{CTout}\|}{\|i_2\|} = \frac{\sqrt{\left(1 + \left(RC\omega\,(\,1 + x)\right)^2\right)}}{\sqrt{\left(1 + \left((R_l + R_B + R)C\omega\,\right)^2\right)}}$$

Et le déphasage vaut :

$$\varphi = Arctg\big(RC\omega\,(\,1 + x)\big) - Arctg\big((R_l + R_B + R)C\omega\big)$$

Le courant IC qui circule à travers le condensateur s'écrit quant à lui:

$$i_C = i_2 - i_{CTout} = \frac{i_1}{n}\left(1 - \frac{1 + jRC\omega\,(\,1 + x)}{(1 + j(R_l + R_B + R)C\omega)}\right)$$

Soit :

$$i_C = \frac{i_1}{n}\left(\frac{(j(R_l + R_B - xR)C\omega)}{(1 + j(R_l + R_B + R)C\omega)}\right)$$

La connaissance de ce courant parasite $I_c$ permet de fixer le seuil de la protection différentielle.

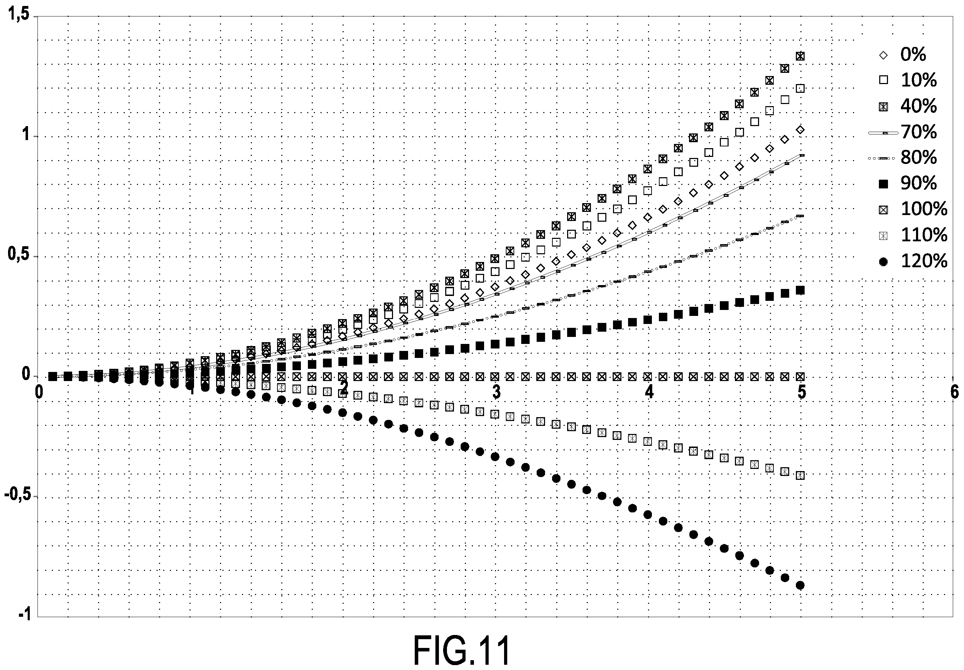

Sur la figure 11 est représenté un réseau de courbes représentant, en ordonnée du graphique, le pourcentage d'erreur faite sur la mesure du courant primaire $I_1$ paramétré en fonction de la valeur R, vérifiant la relation R=y($R_l$+$R_B$), de la résistance de protection 7 du dispositif de mesure du courant 1, avec $R_l$ ayant une valeur de 8,5 Ohms et $R_b$ ayant une valeur de 3 Ohms. En abscisse on a représenté la valeur du condensateur en microfarad. Chaque courbe représente le pourcentage d'erreur en fonction de la valeur du condensateur pour une valeur de y différente. La valeur de y est exprimée en pourcentage en légende sur le figure (0%, 10%, 40%, 70%, 80%, 90%, 100%, 110%, 120%). La courbe avec y=0% correspond à la représentation pour un circuit ne comprenant pas de résistance 7 (valeur nulle de R). De plus pour ce réseau de courbes, la valeur du rapport x des nombres de tours des deux tores a été fixée à 1 traduisant une égalité du nombre de tours des deux tores magnétiques 2 et 3.

On remarque qu'à partir d'une valeur du coefficient y de 60% (y=0,6), le dispositif de mesure de courant 1 selon le premier mode de réalisation de l'invention minimise l'erreur de mesure par rapport à une solution connue de l'état de la technique avec un transformateur d'intensité et un condensateur seul correspondant à la courbe avec y=0.

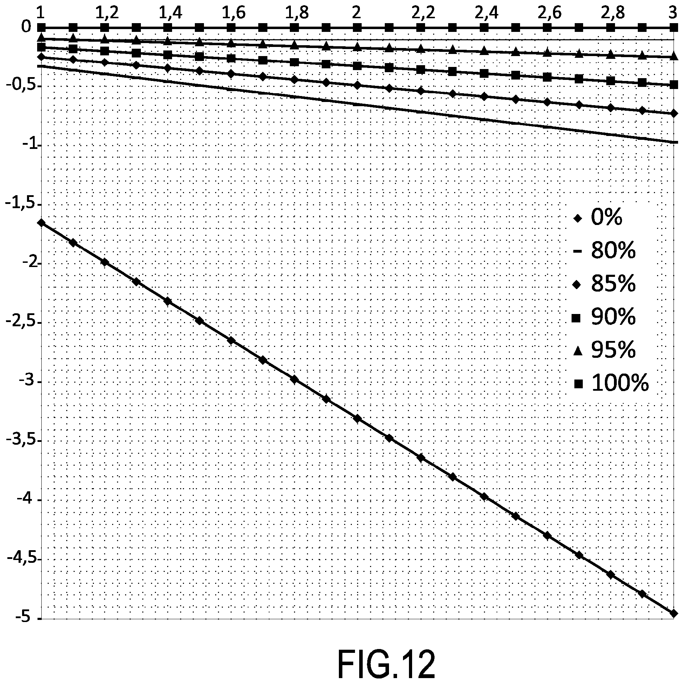

Sur la figure 12, on a représenté un réseau de courbes représentant, en ordonnée du graphique, le déphasage en degré entre le courant $I_1$ à mesurer et le courant mesuré paramétré en fonction de la valeur R, vérifiant la relation R=y($R_l$+$R_B$), de la résistance de protection 7 du dispositif de mesure du courant, avec $R_l$ ayant une valeur de 8,5 Ohms et $R_b$ ayant une valeur de 3 Ohms. En abscisse on a représenté la valeur du condensateur en microfarad. Chaque courbe représente le déphasage en fonction de la valeur du condensateur pour une valeur de y différente. La valeur de y est exprimée en pourcentage en légende sur la figure 12 (0%, 80%, 85%, 90%, 95%, 100%). La courbe avec y=0% correspond à la représentation pour un circuit ne comprenant pas de résistance 7 (valeur nulle de R).

On constate que pour une valeur du coefficient y supérieure à 80% (y>0,8), qui correspond à une connaissance de $R_l$+$R_B$ à moins de 20% près, on obtient un gain sensible en terme de déphasage. Le déphasage est sensiblement réduit par rapport à une solution classique de l'état de la technique avec un transformateur d'intensité et un condensateur seul correspondant à la courbe avec y=0.

Pour une résistance du bobinage des tores magnétiques 2 et 3 de 12 Ohms, une valeur R de la résistance de protection 7 de 11,5 Ohms, un nombre $N_1$ et $N_2$ de 1500 spires pour chacun des premier et second tores magnétiques 2 et 3 et un courant à mesure $I_{1eff}$ de 260 A, le dispositif de mesure de courant 1 présente en fonctionnement nominal, c'est-à-dire lorsque la résistance de charge 6 est correctement connectée, des pertes de puissance réduites puisqu'elles sont de l'ordre de 1,06 W répartis de la manière suivante : 0,34 W via la résistance de protection 7 et 0,36 W via chacun des deux tores magnétiques 2 et 3. Avec les mêmes paramètres de fonctionnement, en fonctionnement avec la résistance de charge 6 déconnectée, le dispositif de mesure de courant 1 présente des pertes de puissance également réduites pour un fonctionnement en défaut puisqu'elles sont de l'ordre de 2,1 W répartis de la manière suivante : 1,38 W via la résistance de protection 7 et 0,36 W via chacun des deux tores magnétiques 2 et 3.

Ainsi, en cas de défaut du dispositif de mesure du courant 1 par ouverture du transformateur d'intensité notamment, le dispositif 1 selon l'invention présente moins de pertes qu'une solution de l'état de la technique utilisant par exemple un écrêteur.

Dans d'autres modes de réalisation, le moyen de dérivation du courant peut être différent d'un condensateur. Il peut être par exemple un tranzorb, ou un écrêteur, ou bien un montage en série de deux diodes Zener montées têtes bêches, ou encore un montage en parallèle d'une première branche comportant un nombre k de diodes montées en série dans un premier sens passant avec une seconde branche comportant un même nombre k de diodes montées en série dans un second sens passant opposé au premier sens passant

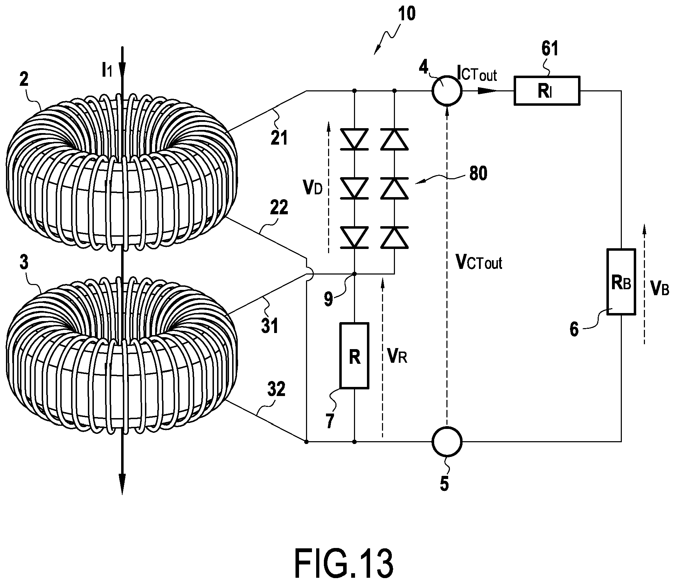

Sur la figure 13 est représenté schématiquement un circuit électrique d'un dispositif de mesure de courant selon un second mode de réalisation de l'invention.

Les éléments du dispositif de mesure de courant 10 identiques au dispositif de mesure du courant 1 du premier mode de réalisation illustré sur la figure 10 portent les mêmes références numériques.

Le dispositif de mesure de courant 10 selon le second mode de réalisation diffère du dispositif de mesure de courant 1 selon le premier mode de réalisation illustré sur la figure 10 par la capacité 8 formant le moyen de dérivation du courant qui a été remplacée par un montage en parallèle d'une première branche comportant trois diodes montées en série dans un premier sens passant avec une seconde branche comportant également trois diodes montées en série mais dans un second sens passant opposé au premier sens passant.

La valeur R de la résistance de protection 7 étant choisie pour être la plus proche possible de la somme de la valeur $R_l$ de l'impédance de ligne 61 avec la valeur $R_B$ de la résistance de charge 6, en fonctionnement nominal du dispositif de mesure du courant 10, la tension aux bornes des diodes n'est pas suffisante pour les rendre passantes.

Ainsi aucune erreur de mesure supplémentaire n'est apportée par ce mode de réalisation.

En cas de déconnexion de la résistance de charge 6, le courant de mesure $I_2$ force la fermeture des trois diodes suivant le sens de circulation du courant dans le bobinage secondaire du premier tore magnétique 2.

Le nombre k de diodes à mettre en série sur chaque branche du moyen de dérivation du courant dans le second mode de réalisation est donné par la relation suivante :

$$k > (1-y)\frac{I_1}{nV_{seuil}}(R_l + R_B)$$

Pour une résistance du bobinage des tores magnétiques 2 et 3 de 12 Ohms, une valeur R de la résistance de protection 7 de 11,5 Ohms, un nombre $N_1$ et $N_2$ de 1500 spires pour chacun des premier et second tores magnétiques 2 et 3 et un courant à mesure $I_{1eff}$ de 260 A, le dispositif de mesure de courant 1 présente en fonctionnement nominal, c'est-à-dire lorsque la résistance de charge 6 est correctement connectée, des pertes de puissance réduites puisqu'elles sont de l'ordre de 1,06 W, ce qui est égale aux pertes en fonctionnement nominale du dispositif de mesure de courant dans le premier mode de réalisation. Avec les mêmes paramètres de fonctionnement, en fonctionnement avec la résistance de charge 6 déconnectée, le dispositif de mesure de courant 1 présente des pertes de puissance également réduites pour un fonctionnement en défaut puisqu'elles sont de l'ordre de 2,725 W répartis de la manière suivante : 1,38 W via la résistance de protection 7, 0,36 W via chacun des deux tores magnétiques 2 et 3, et 0,625 W via le montage de diodes.

Ainsi, en cas de défaut du dispositif de mesure du courant 10 par ouverture du transformateur d'intensité notamment, le dispositif 10 selon l'invention présente également moins de pertes qu'une solution de l'état de la technique utilisant par exemple un écrêteur.

Protéger un TI contre les surtensions en cas d'ouverture du circuit secondaire a un coût notamment en terme de masse. Les solutions classiques exposées ci-dessus montrent que si on veut être tolérant à ce type de défaut de façon permanente, il faut à minima doubler la masse du moyen de mesure, et donc potentiellement son prix, notamment à cause des moyens de dissipation d'énergie calorifique à prévoir.

L'objet selon l'invention proposée double elle aussi le prix et la masse du TI classique non protégé. Cependant, elle offre le cumule des avantages suivants :

- Protection des opérateurs en cas de défaut TI, notamment en cas d'ouverture du TI au niveau du circuit secondaire.
- Compatibilité avec l'avion à structure Carbone en ce qui concerne les seuils minimum de courant de défauts à détecter.
- Tenue en permanent en cas de défaut TI.

Ces solutions sont envisageables pour les réseaux triphasés de puissances supérieures à 90kVA ce qui n'est pas forcément le cas des solutions utilisant des écrêteurs qui sont limités par la puissance pouvant être dissipée.

Le gain de masse entrainé par l'avion « carbone » peut justifier l'augmentation de masse et de coût de cette solution sachant qu'elle est la seule compatible au besoin de précision lié à cette nouvelle technologie « carbone » et qu'elle offre en même temps une protection efficace en cas de défaut tant pour l'opérateur que pour l'équipement dans lequel elle est installée.

## Revendications

**1.** Dispositif (1, 10) de mesure d'un courant protégé contre les surtensions en cas d'ouverture du circuit électrique dudit dispositif (1, 10), le dispositif (1, 10) comprenant un premier transformateur d'intensité (2) configuré pour mesurer par induction l'intensité du courant électrique ($I_1$) circulant dans un circuit électrique traversant ledit premier transformateur d'intensité (2), une première borne de connexion (4) à laquelle est raccordée une première borne (21) dudit premier transformateur d'intensité (2), une seconde borne de connexion (5) à laquelle est raccordée une seconde borne (22) dudit premier transformateur d'intensité (2) distincte de ladite première borne (21) du premier transformateur d'intensité (2), une résistance de protection (7) dont une première borne (71) est raccordée à la seconde borne de connexion (5), et une résistance de charge (6) raccordée entre la première et la seconde bornes de connexion (4 et 5) et aux bornes de laquelle est mesurée une tension à partir de laquelle on détermine le courant circulant dans le circuit traversant le premier transformateur d'intensité (2),
**caractérisé en ce qu'**il comprend un second transformateur d'intensité (3) configuré pour mesurer par induction l'intensité dudit courant électrique ($I_1$), le second transformateur d'intensité (3) étant raccordé aux première et seconde bornes (71, 72) de la résistance de protection (7), et un moyen de dérivation du courant (8, 80) raccordé entre ladite première borne de connexion (4) et la seconde borne (72) de la résistance de protection (7).

2. Dispositif (1, 10) selon la revendication 1, dans lequel la résistance de protection (7) possède une valeur ohmique (R) correspondant, à 20% près et plus particulièrement à 10% près, à la somme de la valeur ohmique ($R_B$) de la résistance de charge (6) avec la valeur ohmique ($R_l$) de l'impédance de ligne (61) correspondant à la résistance de la ligne électrique couplant la résistance de charge (6) aux première et seconde bornes de connexion (4 et 5).

3. Dispositif (1, 10) selon l'une des revendications 1 ou 2, dans lequel les premier et second transformateurs d'intensité (2 et 3) sont des tores magnétiques identiques possédant notamment le même noyau magnétique et le même nombre de spires ($N_1$ et $N_2$).

4. Dispositif (1) selon l'une des revendications 1 à 3, dans lequel le moyen de dérivation du courant comprend un condensateur (8).

5. Dispositif selon l'une des revendications 1 à 3, dans lequel le moyen de dérivation du courant comprend un moyen d'écrêtage tel qu'un tranzorb.

6. Dispositif (10) selon l'une des revendications 1 à 3, dans lequel le moyen de dérivation du courant comprend un montage en parallèle (80) d'une première branche comportant un nombre k de diodes montées en série dans un premier sens passant avec une seconde branche comportant un même nombre k de diodes montées en série dans un second sens passant opposé au premier sens passant.

7. Dispositif selon l'une des revendications 1 à 3, dans lequel le moyen de dérivation du courant comprend un montage en série de deux diodes Zener tête bêches.

8. Dispositif (1, 10) selon l'une des revendications 1 à 7, comprenant en outre un dispositif de détection de défaut des moyens de mesure du courant de la tension aux bornes de la résistance de charge (6).

9. Système de mesure triphasé des courants circulant dans les trois phases d'un circuit triphasé, le système comprenant trois dispositifs (1, 10) de mesure selon l'une des revendications 1 à 8, les secondes bornes de connexion des dispositifs étant couplées ensemble.

10. Aéronef comprenant au moins un dispositif de mesure du courant selon l'une des revendications 1 à 9.

**Patentansprüche**

1. Vorrichtung (1, 10) zum Messen eines Stroms, die vor Überspannungen im Fall einer Öffnung des elektrischen Stromkreises der Vorrichtung (1, 10) geschützt ist, wobei die Vorrichtung (1, 10) einen ersten Stromwandler (2) umfasst, der ausgelegt ist, um durch Induktion die Stärke des elektrischen Stroms ($I_1$) zu messen, der in einem elektrischen Stromkreis fließt, der den ersten Stromwandler (2) durchquert, eine erste Anschlussklemme (4), an die eine erste Klemme (21) des ersten Stromwandlers (2) angeschlossen ist, eine zweite Anschlussklemme (5), an die eine zweite Klemme (22) des ersten Stromwandlers (2) angeschlossen ist, die von der erstem Klemme (21) des ersten Stromwandlers (2) verschieden ist, einen Schutzwiderstand (7), von dem eine erste Klemme (71) an die zweite Anschlussklemme (5) angeschlossen ist, und einen Lastwiderstand (6), der zwischen der ersten und der zweiten Anschlussklemme (4 und 5) angeschlossen ist und an den dessen Klemmen eine Spannung gemessen wird, von der ausgehend der Strom bestimmt wird, der in dem Kreis fließt, der den ersten Stromwandler (2) durchquert, **dadurch gekennzeichnet, dass** sie einen zweiten Stromwandler (3) umfasst, der ausgelegt ist, um durch Induktion die Stärke des elektrischen Stroms ($I_1$) zu messen, wobei der zweite Stromwandler (3) an die erste und zweite Klemme (71, 72) des Schutzwiderstands (7) angeschlossen ist, und ein Umleitungsmittel des Stroms (8, 80), das zwischen der ersten Anschlussklemme (4) und der zweiten Klemme (72) des Schutzwiderstands (7) angeschlossen ist.

2. Vorrichtung (1, 10) nach Anspruch 1, wobei der Schutzwiderstand (7) einen Ohmschen Wert (R) besitzt, der bis zirka 20% und insbesondere bis zirka 10% der Summe des Ohmschen Werts ($R_B$) des Lastwiderstands (6) mit dem Ohmschen Wert ($R_l$) der Leitungsimpedanz (61) entspricht, der dem Widerstand der elektrischen Leitung entspricht, die den Lastwiderstand (6) an die erste und zweite Anschlussklemme (4 und 5) koppelt.

**EP 3 405 796 B1**

3. Vorrichtung (1, 10) nach einem der Ansprüche 1 oder 2, wobei der erste und zweite Stromwandler (2 und 3) identische Magnetkerne sind, die insbesondere den gleichen Magnetkern und die gleiche Anzahl an Windungen ($N_1$ und $N_2$) besitzen.

4. Vorrichtung (1) nach einem der Ansprüche 1 bis 3, wobei das Umleitungsmittel des Stroms einen Kondensator (8) umfasst.

5. Vorrichtung nach einem der Ansprüche 1 bis 3, wobei das Umleitungsmittel des Stroms ein Abgleichmittel wie einen Transorb umfasst.

6. Vorrichtung (10) nach einem der Ansprüche 1 bis 3, wobei das Umleitungsmittel des Stroms eine Parallelmontage (80) einer ersten Abzweigung umfasst, die eine Anzahl k von Dioden aufweist, die in einer ersten Durchgangsrichtung mit einer zweiten Abzweigung in Reihe montiert sind, die dieselbe Anzahl k von Dioden aufweist, die in einer zweiten Durchgangsrichtung entgegengesetzt zur ersten Durchgangsrichtung in Reihe montiert sind.

7. Vorrichtung nach einem der Ansprüche 1 bis 3, wobei das Umleitungsmittel des Stroms eine Montage von zwei entgegengesetzten Zener-Dioden in Reihe umfasst.

8. Vorrichtung (1, 10) nach einem der Ansprüche 1 bis 7, umfassend ferner eine Fehlerdetektionsvorrichtung der Messmittel des Stroms der Spannung an den Klemmen des Lastwiderstands (6).

9. Dreiphasenmesssystem der Ströme, die in den drei Phasen eines Dreiphasenkreises fließen, wobei das System drei Messvorrichtungen (1, 10) nach einem der Ansprüche 1 bis 8 umfasst, wobei die zweiten Anschlussklemmen der Vorrichtungen zusammengekoppelt sind.

10. Luftfahrzeug, umfassend mindestens eine Strommessvorrichtung nach einem der Ansprüche 1 bis 9.

**Claims**

1. A current measuring device (1, 10) that is protected against electrical surges when opening the electric circuit of said device (1, 10), said device (1, 10) comprising a first current transformer (2), a first connection terminal (4) having connected thereto a first terminal (21) of said first current transformer (2), a second connection terminal (5) having connected thereto a second terminal (22) of said first current transformer (2) distinct from said first terminal (21) of said first current transformer (2), a protective resistance (7) having a first terminal (71) connected to said second connection terminal (5), and a load resistance (6) connected between said first and second connection terminals (4 and 5) across the terminals of which a voltage is measured from which the current flowing in a circuit passing through said first current transformer (2) is determined, said device being **characterized in that** it includes a second current transformer (3) connected to said first and second terminals (71, 72) of the protective resistance (7), and current branch connection means (8, 80) connected between said first connection terminal (4) and said second terminal (72) of said protective resistance (7).

2. A device (1, 10) according to claim 1, wherein the protective resistance (7) possesses a resistance value (R) corresponding, to within 20% and more particularly to within 10%, to the sum of the resistance value ($R_B$) of the load resistance (6) plus the resistance value ($R_\ell$) of the line impedance (61) corresponding to the resistance of the electric line coupling the load resistance (6) to the first and second connection terminals (4 and 5).

3. A device (1, 10) according to claim 1 or claim 2, wherein the first and second current transformers (2 and 3) are identical magnetic toruses possessing in particular the same magnetic cores and the same number of turns ($N_1$ and $N_2$).

4. A device (1) according to any one of claims 1 to 3, wherein the current branch connection means comprise a capacitor (8).

5. A device according to any one of claims 1 to 3, wherein the current branch connection means comprise peak-limiter means such as a tranzorb.

6. A device (10) according to any one of claims 1 to 3, wherein the current branch connection means comprise a

**12**

parallel connection (80) having a first branch with a number k of diodes connected in series to conduct in a first direction and a second branch comprising the same number k of diodes connected in series to conduct in a second direction opposite to the first direction.

7. A device according to any one of claims 1 to 3, wherein the current branch connection means comprise a series connection of two zener diodes connected opposite ways round.

8. A device (1, 10) according to any one of claims 1 to 7, further comprising a fault detection device for detecting a fault in the current measuring means for measuring the voltage across the terminals of the load resistance (6).

9. A three-phase measurement system for measuring current flowing in the three-phases of a three-phase circuit, the system comprising three measuring devices (1, 10) according to any one of claims 1 to 8, the second connection terminals of the devices being connected together.

10. An aircraft including at least one current measuring device according to any one of claims 1 to 9.

# FIG.1
## ART ANTERIEUR

# FIG.2
## ART ANTERIEUR

# FIG.3
## ART ANTERIEUR

# FIG.4
## ART ANTERIEUR

FIG.5
ART ANTERIEUR

FIG.6
ART ANTERIEUR

VCT out (pic)

## FIG.7
## ART ANTERIEUR

## FIG.8
## ART ANTERIEUR

# FIG.9
## ART ANTERIEUR

# FIG.10

FIG.11

FIG.12

FIG.13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012050923 A1
- US 2015333509 A1
- WO 2009047748 A2